Europäisches Patentamt

European Patent Office

Office européen des brevets

(19)

(11) Publication number: **0 093 848**
**A2**

# EUROPEAN PATENT APPLICATION

(12)

(21) Application number: **83102117.5**

(22) Date of filing: **04.03.83**

(51) Int. Cl.³: **H 01 L 21/324**, H 01 L 21/316

(30) Priority: **12.05.82 US 377295**

(43) Date of publication of application: **16.11.83 Bulletin 83/46**

(84) Designated Contracting States: **DE FR GB**

(71) Applicant: **International Business Machines Corporation, Old Orchard Road, Armonk, N.Y. 10504 (US)**

(72) Inventor: **Fayo, Emily Mae, B27 Candlestick Park, Newburgh New York 12550 (US)**
Inventor: **Orner, Carl Henry, 39 Crown Boulevard, Newburgh New York 12550 (US)**

(74) Representative: **Rudack, Günter O., Dipl.-Ing., Säumerstrasse 4, CH-8803 Rüschlikon (CH)**

(54) **Semiconductor device fabrication process utilizing an added annealing step.**

(57) An improvement in the method of fabricating semiconductor devices to reduce device leakage by intervening a hydrogen annealing step at about 900 °C for about 30 minutes after the steps of epitaxial growth and before the step of oxidation of that epitaxial layer.

```
┌─────────────────────┐
│   FIRST OXIDATION    │
└─────────────────────┘
           │
┌─────────────────────┐
│   DIFFUSION OF THE   │
│ SUB-COLLECTOR REGIONS│
└─────────────────────┘
           │
┌─────────────────────┐
│ SUB-COLLECTOR OXIDATION │
└─────────────────────┘
           │
┌─────────────────────┐
│  ISOLATION DIFFUSION │
│     AND DRIVE-IN     │
└─────────────────────┘
           │
┌─────────────────────────┐
│ EPITAXIAL LAYER FORMATION │
│    OF N-TYPE SILICON     │
└─────────────────────────┘
           │
┌─────────────────────┐
│   HYDROGEN ANNEAL    │
└─────────────────────┘
           │
┌─────────────────────────┐
│ EPITAXIAL LAYER OXIDATION │
└─────────────────────────┘
```

ACTORUM AG

0093848

## SEMICONDUCTOR DEVICE FABRICATION PROCESS
## UTILIZING AN ADDED ANNEALING STEP

This invention relates to semiconductor devices and more particularly to an improvement in the process for fabricating such devices.

The microscopic dimensions of very large scale integrated circuit devices requires extremely close control over the material properties. Microscopic material defects that could formerly be tolerated in low density devices now become large with respect to high density integrated circuit devices, and will frequently render the device unfit for use. Because integrated circuits are fabricated en masse on a chip/wafer, microscopic defects may cause the wafer to be scrapped or at least compel the segregation of good and bad chips.

Junction and pipe leakage in semiconductor devices are particularly prejudicial to the integrity of the devices. Various prior art practitioners have sought by one means or another to minimize or eliminate these and other faults through annealing between various steps in the process.

Levinson, et al in U.S. Patent No. 4,149,905 teaches the use of an argon-hydrochloric anneal of the wafers just prior to oxidation so as to remove impurities from the surface of the wafers and thus limit the sites at which stacking faults form after oxidation.

Srinivasan in U.S. Patent No. 4,153,486 describes a method for depositing a silicon epitaxy with very low defect levels. The substrate is baked between $1120^{\circ}C$ and $1180^{\circ}C$ in hydrogen prior to the formation of the epitaxial layer.

0093848

By inserting a hydrogen annealing step between the steps of forming the epitaxial layer and the oxidation of that layer, the electrically active defects in the epitaxial layer are substantially eliminated so as to produce a semiconductor device free of junction and pipe leakage defects.

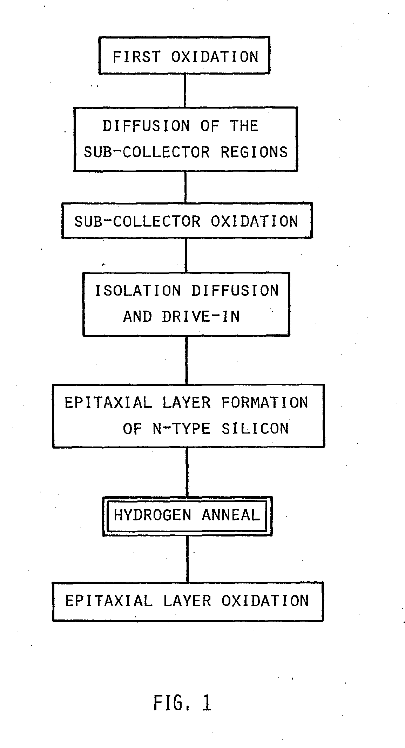

Referring to the process flow diagram of Fig. 1 which summarizes the generic steps used to produce a typical silicon semiconductor integrated circuit structure on a wafer, it will readily be appreciated that the detailed steps of cleaning, photoresist deposition, mask preparation, etc. have been eliminated as these have all been abundantly described in the prior art and form no part of the instant invention. Only those steps prior to and immediately following the step which constitutes the process improvement are illustrated.

The new step of hydrogen anneal is carried out at a temperature chosen from the range of $800^{\circ}$ to $1000^{\circ}$ with $900^{\circ}$C being the preferred temperature for a period of 20 to 40 minutes, with an optimum time of about 30 minutes. Little or no improvement in leakage is observed beyond 40 minutes. The ambient gas is either pure hydrogen or a hydrogen derived ambient such as forming ($\sim 10\%$ $H_2$) at atmospheric pressure.

The hydrogen ambient acts on the silicon surface and/or near the surface to generate, and/or transfer from the bulk, nucleation sites. As a result, contaminant impurities normally associated with leakage will be depleted from the bulk regions and gathered to the nucleation centers. In addition to the foregoing mechanism, the hydrogen anneal ambient has been shown to deactivate electrically active defects (EAD's) such as epitaxy stacking faults. Such crystal imperfections are not by themselves a cause of leakage since good device structures have been fabricated with such lattice defects. However, such defects are known to getter surrounding impurity contaminants, such as the heavy metals, to create electrically active lattice defects. The anneal is believed to vaporize the contaminants by forming high vapor pressure hydrides.

In separate experiments wherein (a) no annealing was performed, (b) an argon anneal was performed and (c) a hydrogen forming gas anneal was performed. The respective number of EAD's were (a) 280, (b) 11 and (c) 0, attesting to the efficacy of an anneal versus no anneal and the efficacy of a hydrogen anneal versus an argon anneal. All other process parameters were the same, as were the device geometries. This result was verified in other experiments using float zone wafers (no interstitial oxigen) wherein (a) no annealing, (b) $H_2$ annealing in an epitaxy reactor, (c) $N_2$ annealing in oxidation tube, (d) forming gas (10% $H_2$) annealing in oxidation tube was performed. Respective average MOS lifetime in microseconds were (a) .01, (b) .2, (c) .01 and (d) .3.

While it has been found that the low temperature hydrogen ambient atmosphere annealing is particularly effective in reducing defects in the epitaxial layer, there is some evidence that a similar annealing at other stages of the process is equally effective in reducing defects. Therefore, while the invention has been described with respect to the preferred embodiment, it will be appreciated that suitable modifications can be made without departing from the spirit and scope of the invention.

# C L A I M S

1. Process for fabricating silicon semiconductor devices including the steps of growing an epitaxial layer upon the silicon wafer and thereafter oxidizing the thus-processed wafer, characterized by the addition of a step, between the said two steps, consisting of annealing the wafer in an ambient reducing atmosphere containing from about 10% to 100% hydrogen at a temperature between $800^\circ$ and $1000^\circ C$ for a time between 20 minutes and 40 minutes.

2. Process according to claim 1, characterized in that the temperature is $900^\circ C$ and the time is 30 minutes.

3. Process according to claim 1, characterized in that the hydrogen ambient is derived from forming gas.

```
┌─────────────────────────┐
│     FIRST OXIDATION     │
└─────────────────────────┘
             │
┌─────────────────────────┐
│     DIFFUSION OF THE    │
│   SUB-COLLECTOR REGIONS │
└─────────────────────────┘
             │
┌─────────────────────────┐
│  SUB-COLLECTOR OXIDATION │
└─────────────────────────┘
             │
┌─────────────────────────┐
│   ISOLATION DIFFUSION   │
│       AND DRIVE-IN      │
└─────────────────────────┘
             │
┌─────────────────────────┐
│ EPITAXIAL LAYER FORMATION│
│     OF N-TYPE SILICON   │
└─────────────────────────┘
             │
┌─────────────────────────┐
│     HYDROGEN ANNEAL     │
└─────────────────────────┘
             │
┌─────────────────────────┐
│ EPITAXIAL LAYER OXIDATION│
└─────────────────────────┘
```

FIG. 1